# EUROPEAN PATENT SPECIFICATION

(11) **EP 4 125 125 B1**
(45) Date of publication and mention of the grant of the patent: **18.11.2026**
(21) Application number: 22187456.3
(22) Date of filing: 28.07.2022
(51) Int. Cl.: H10W 70/40, H10W 70/04

(54) **METHOD OF PRODUCING SUBSTRATES FOR SEMICONDUCTOR DEVICES**
VERFAHREN ZUM PRODUZIEREN VON SUBSTRATEN FÜR HALBLEITERBAUELEMENTE
PROCÉDÉ DE FABRICATION DE SUBSTRATS POUR DISPOSITIFS À SEMICONDUCTEUR

(30) Priority: 30.07.2021 IT 202100020555
(43) Date of publication of application: 01.02.2023
(73) Proprietor: STMicroelectronics S.r.l., 20864 Agrate Brianza (MB) (IT)
(72) Inventor: MAZZOLA, Mauro, 24040 Calvenzano (Bergamo) (IT); TIZIANI, Roberto, 20014 Nerviano (Milano) (IT)
(74) Representative: Buzzi, Notaro & Antonielli d'Oulx S.p.A.

(56) References cited:
- JP-B2- 5 813 335
- US-A1- 2011 115 061
- US-A1- 2017 301 617

## Description

### Technical field

The description relates to semiconductor devices.

One or more embodiments can be applied to semiconductor power devices for use in the automotive sector, in consumer electronics, in computers and various other applications.

Power Supply Units (PSUs) for servers, laptop chargers, phone chargers and USB wall plugs are just a few examples of possible applications of embodiments.

### Background

Various semiconductor devices, such as power Quad-Flat No-leads (QFN) packages, benefit from the presence of an insulated die pad wherein the package leadframe is half-etched at the die pad area to create an insulating resin layer below the half-etched die pad.

Various issues may arise in producing such a pre-molded leadframe: for instance, leadframe clamping during pre-molding may not be completely effective in so far as, at the half-etched die pad, the metal (copper) in the leadframe structure is just part (half) of its initial thickness.

As a result, the molding tool comes into contact with the front (top) surface of the die pad, which, however, is not supported at its back or bottom surface.

The die pad may thus become somehow floating in the molding tool and resin "flashes" (that is, resin smearing or leaking onto the die pad) may be produced at the front or top surface of the die pad that cannot be removed via de-flashing and/or polishing.

Document US 2011/115061 A1 discloses an electronic device including a packaging material having a first surface and a second surface opposite the first surface, and leads including die connection surfaces and external connection surfaces. The electronic device further includes a trench extending from an upper surface of the packaging substrate towards a lower surface of the packaging substrate, wherein a set of leads lie immediately adjacent to the trench, and the packaging material is exposed at the bottom of the trench. An encapsulant is formed over the upper surface of the packaging substrate and within the trench. The trenches may be formed before or after placing a die over the packaging substrate, or before or after forming electrical connections between the die and leads of the packaging substrate.

Also documents JP 5 813335 B2 and US 2017/301617 A1 are of interest for the invention.

### Object and summary

An object of one or more embodiments is to contribute in addressing the issues discussed in the foregoing.

According to one or more embodiments, that object can be achieved by means of a method having the features set forth in claim 1 that follows.

The claims are an integral part of the technical teaching provided herein in respect of the embodiments.

One or more embodiments may provide a pre-molded QFN leadframe comprising sacrificial pillars to facilitate proper clamping of the half-etched die pad(s) intended to be embedded in pre-mold resin.

These sacrificial pillars can be removed during a subsequent half-etch step performed after final leadframe molding to form wettable-flanks for lead soldering, for instance.

Advantageously, one or more embodiments can provide increased anchoring of a second mold (encapsulation) to the pre-mold resin in the leadframe.

A pre-molded leadframe according to embodiments comprises one or more half-etched insulated die pads having support pillars extending towards the back or bottom side of the leadframe.

Advantageously, these support pillars comprise a hollow central portion on the front or top side. A final pre-molded leadframe can thus be produced (for use in manufacturing QFN packages, for instance) including cavities in the form of through holes.

A second mold (encapsulation) material can thus penetrate into these holes and come into contact with the pre-mold resin. Strong coupling (adhesion) between the pre-mold resin and the encapsulation can thus be achieved even in the presence of different types and/or amounts of fillers in the pre-mold resin and in the encapsulation.

### Brief description of the annexed figures

One or more embodiments will now be described, by way of example, with reference to the annexed figures, wherein:
Figures 1A and 1B are exemplary of steps in conventional manufacturing of pre-molded substrates (leadframes);
Figure 1C is a schematic representation of a substrate obtained with the steps of Figures 1A and 1B;
Figures 2A and 2B are exemplary of steps in conventional manufacturing of pre-molded substrates (leadframes) including a half-etched die pad;
Figure 2C is a schematic representation of a substrate that can be obtained with the steps of Figures 2A and 2B;
Figure 3 is a view of a portion of Figure 2C indicated by arrow III, reproduced on an enlarged scale;
Figures 4A and 4B are exemplary of certain steps which may be attempted in order to dispense with defects as illustrated in Figure 3;
Figures 5A to 5F are illustrative of steps in embodiments of the present description; and
Figures 6A and 6B are perspective views from opposed viewpoints of a substrate structure according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

Semiconductor devices comprise one or more semiconductor chips or dice arranged (attached) on substrates such as leadframes.

Plastic packages are commonly used for semiconductor devices. Such packages may include a leadframe providing a base substrate comprising electrically conductive material (metal such as copper, for instance) sized and shaped to accommodate semiconductor chips or dice and providing pad connections (leads) for these chips or dice.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Leadframes are conventionally created using technologies such as a photo-etching technology. With this technology, metal material in the form of a foil or tape is etched on the top and bottom sides to create various pads and leads.

Quad-Flat No-lead (QFN) is a semiconductor device package family exhibiting a high growth rate in the area of semiconductor packaging.

QFN is a flexible and inexpensive package type with a wide range of possible applications and a pin count that may range between 2 pins (in the case of a diode, for instance) to 100 pins or more (in multiple-row arrangements for digital integrated circuits, for instance).

It is noted that the designation "No-leads" applied to QFN packages refers to the fact that a QFN package typically has no leads protruding radially from the package, the leads or pins being in fact provided at the back or bottom surface of the package.

Leadframes for use as substrates for mounting QFN packages are advantageously provided in a "pre-molded" version wherein an insulating resin (an epoxy resin, for instance) fills the empty spaces between the die pads and leads.

Pre-molded leadframes are currently used including electrically insulating resin such as epoxy resin, for instance, molded onto a sculptured electrically conductive (e.g., metal) laminar structure using a flat molding tool, for instance.

Spaces left in the etched metal material (e.g., copper) are filled by pre-molding resin and the resulting leadframe has a total thickness which is the same thickness of the original etched leadframe.

After pre-molding (with the molded resin solidified, via heat or UV curing, for instance), de-flashing and smearing processes can be applied to provide clean top/bottom metal surfaces.

Wettable flanks can be provided, e.g., during a second etching step which can be applied to the pre-molded leadframe to generate dedicated etched areas.

Pre-molded leadframes offer various advantages in the process assembly flow (primarily in respect of wire bonding and molding).

Pre-molded leadframes are also advantageous in terms of design, for instance where plural die pads and fairly complex lead routing (for multi-chip applications, for instance) are features of interest.

A substrate in the form of the pre-molded leadframe can be manufactured using photo-etching technology starting from a sheet or strip of a metal material (copper, for instance) which is etched at the top and bottom sides to create the pads and die pads plus leads.

An insulating resin such as an epoxy resin is then molded (via a transfer technology, for instance). During molding of the resin, a mold tool is applied clamping the leadframe with the mold surfaces placed against the leadframe structure. A low-viscosity resin can be used to facilitate good flow and filling.

The pads (leads) and die pads are essentially exempt from mold flash (that is, mold resin smearing or leaking onto the pad surface) with moderate resin bleeding occurring locally. De-flashing and polishing processes can be applied after resin molding to obtain a clean metal surface (in view of Ag or NiPdAu finishing, for instance).

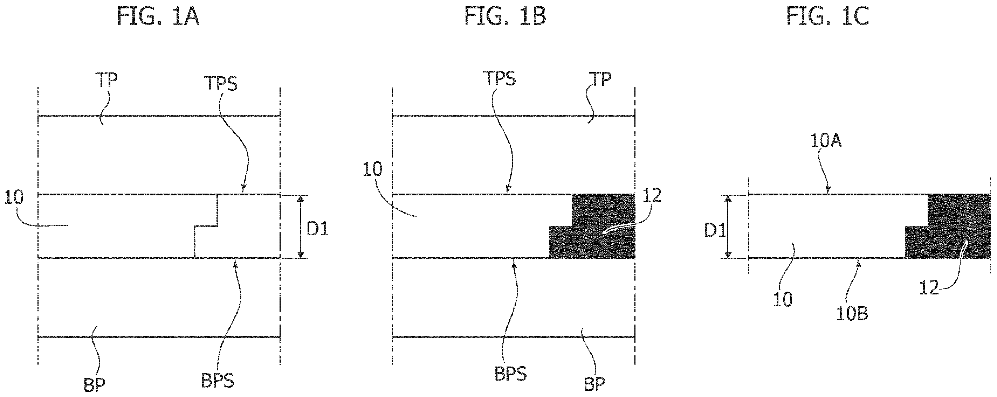

The sequence of Figures 1A to 1C is schematically exemplary of a sequence of steps as discussed in the foregoing.

Specifically, in Figures 1A to 1C reference 10 denotes a die pad included in a sculptured, electrically conductive laminar structure of a leadframe (substrate). Such a sculptured structures has spaces therein that are originally empty and are then filled by pre-mold material 12 (resin such as an epoxy resin, for instance) molded onto the sculptured, electrically conductive laminar structure of a leadframe.

As illustrated in Figures 1A and 1B - these can be regarded essentially as partial cross-sectional views though the substrate (leadframe) 10 - the pre-mold material is supplied in a flowable state while the laminar structure 10 is clamped between the planar clamping surfaces of pre-mold tool comprising a first (top) part TP and a second (bottom) part BP.

The planar clamping surfaces of the pre-mold tool, designated TPS and BPS, respectively, kept at a distance D1 equal to a final desired thickness of the leadframe (see Figure 1C).

The pre-mold material 12 molded onto the laminar structure 10 that is clamped in the pre-mold tool TP, BP penetrates into the originally empty spaces in the sculptured metal structure of the leadframe.

A laminar pre-molded substrate (leadframe) is thus produced having the same thickness D1 of the laminar structure with a front (top) surface 10A of the die pad 10 left exposed (that is, uncovered) by the pre-mold material 12 (even after this is solidified, via UV or heat curing, for instance).

A leadframe structure as exemplified in Figures 1A to 1C facilitates good clamping between the planar clamping surfaces TPS, BPS so that no appreciable "flashing" of the pre-mold material 12 occurs at the surface 10A.

Some marginal resin bleeding over the surface 10A may take place, which can be removed via de-flashing and polishing steps, thus obtaining a clean metal surface 10A available for semiconductor chip mounting.

As visible in Figure 1C, the sculptured metal structure of the leadframe (a die pad, such as 10, for instance) is exposed (that is left uncovered) by the pre-mold material 12, both at front or top surface 10A and at the back or bottom surface, designated 10B.

Various applications of pre-molded leadframes may benefit from the availability of an insulated die pad.

An insulated die pad is exposed (that is, left uncovered by the pre-mold material) only at the front or top surface 10A, while the back or bottom surface 10B is covered by pre-mold material 12. The die pad is thus electrically isolated at its back or bottom surface that is embedded in the molding material 12.

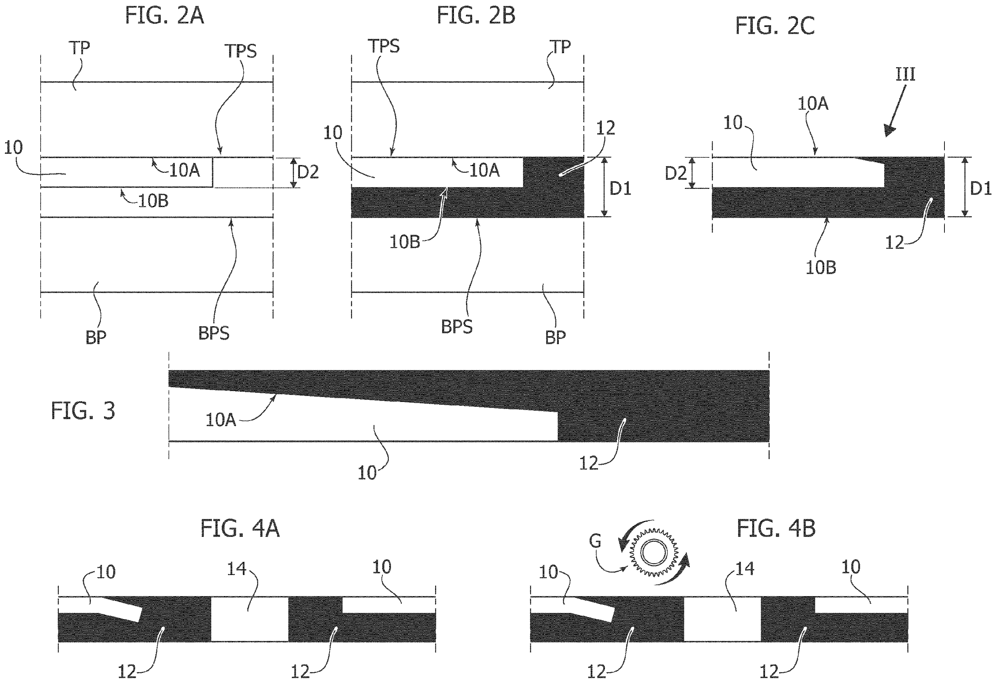

This situation is exemplified in Figures 2A to 2C, where parts or elements already discussed in connection with Figures 1A to 1C are indicated with the same reference symbols, so that the corresponding detailed description will not be repeated for brevity.

In the case of an insulated pad arrangement as exemplified in Figures 2A to 2C, at the die pad 10 the sculptured leadframe (metal) structure exhibits a recessed portion at the back or bottom surface 10B.

At the die pad 10, the sculptured (metal) structure of the leadframe has a second thickness D2, which is less than the general thickness D1 of the pre-molded leadframe (see Figure 2C for immediate reference).

For instance, in cases exemplified in Figures 2A to 2C, the die pad 10 may be a "half-etched" portion of the leadframe having a thickness D2 which is (at least approximately) half the thickness D1.

If the same process discussed previously in connection with Figures 1A and 1B is applied in producing a pre-molded leadframe having such a recessed portion/reduced thickness (e.g., a half-etched die pad 10) clamping between the clamping surfaces TPS and BPS of the clamping tool may not be completely effective.

In fact, in that case the die pad 10 will have:
its front or top surface 10A (the surface intended to host one or more semiconductor chips mounted thereon) adequately abutting against the first planar mold surface TPS, and
its back or bottom surface 10B (opposite the front or top surface 10A) arranged at a distance (given by the difference between D1 and D2) from the second planar mold surface BPS.

Consequently, the back or bottom surface 10B of the die pad 10 will not be supported by the bottom part BP of the molding tool leaving the die pad 10 floating and thus exposed to undesired displacement/bending.

As exemplified by the enlarged view of Figure 3, this may result in undesired "flashing" of the pre-mold material 12 over the front or top surface 10A.

This is a defect likely to lead to rejection of the substrate as a defective product.

Such defect cannot be removed by standard de-flashing and/or polishing steps.

In principle, such a defect could be attempted to be removed by some sort of grinding of the front or top surface of the pre-molded leadframe as indicated by G in Figure 4B.

As illustrated in Figure 4A, the front or top surface of the pre-molded leadframe comprises insulated die pads 10 plus pads or leads 14 (intended to provide the final contact pins of the device package) with the pre-mold material 12 filling the empty spaces in the sculptured metal structure (pads 10 and 14) of the leadframe.

Such possible grinding is found to be hardly feasible and effective.

In fact, the thickness of the pre-mold material 12 flashed onto the top or front surface 10A (see Figure 3) may be in excess of 3 microns.

Grinding may thus undesirably reduce the thickness of the pre-molded leadframe. In turn this may result in undesirable leadframe distortion/delamination and surface damage.

These drawbacks cannot be set aside even resorting to measures such as providing shape-improving features such as zig-zag notches and so on.

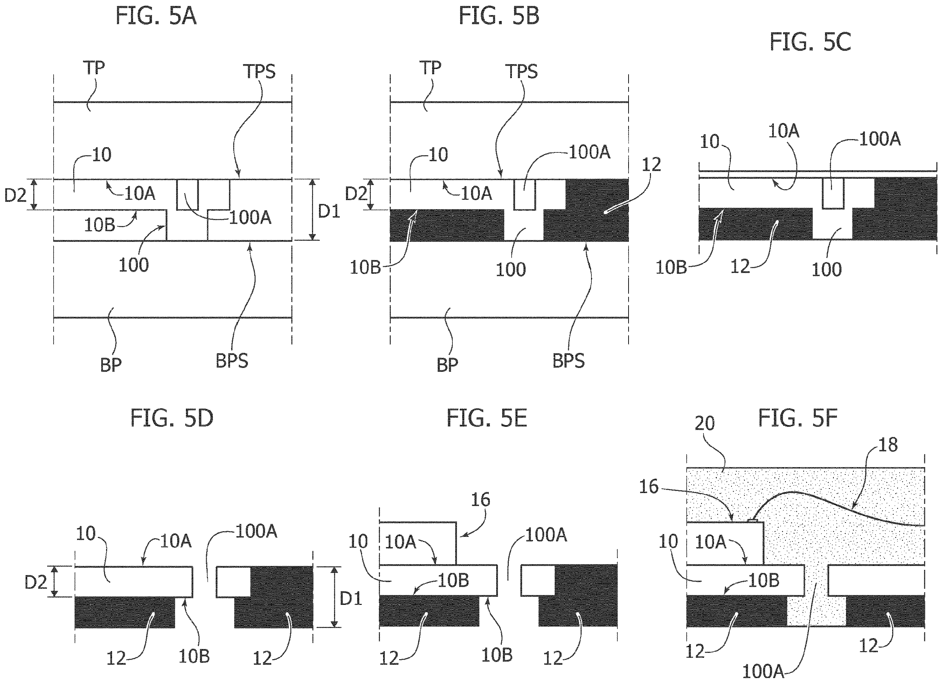

Figures 5A to 5F are exemplary of steps wherein the drawbacks discussed in the foregoing are overcome with a die pad 10 again formed at a recessed portion of the leadframe having a thickness D2 which is less (a half, for instance) the overall thickness D1 of the leadframe.

As illustrated in Figures 5A to 5F, one or more (sacrificial) pillar formations 100 are provided protruding from the back or bottom surface 10B of the die pad 10.

The pillar formation 100 (only one is illustrated for simplicity) has a height equal to D1 minus D2, that is the difference between the first, total thickness D1 of the pre-molded leadframe and the second, smaller thickness D2 at the recessed portion, namely at the die pad 10.

As a result (see Figures 5A and 5B), when the leadframe metal structure of the leadframe is clamped between the clamping surfaces TPS, BPS, the front or top surface 10A will again abut against the surface TPS, and the distal end portion of the pillar formation 100 will likewise abut against the opposite clamp surface BPS. In that way adequate clamping of the sculptured metal structure of the leadframe (no die pad "floating") can be facilitated while the pre-mold material 12 is molded thereon as exemplified in Figure 5B.

In that way, undesired flashing (smearing) of the pre-mold material 12 over the surface 10A can be effectively countered leading to a cleaner surface 10A of the die pad 10, exempt from appreciable flashing of pre-mold material thereover.

Advantageously, the pillar formation(s) 100 can be removed as illustrated in the sequence of Figures 5C and 5D.

For instance, this may occur during an etching step performed (in a manner known per se to those of skill in the art) with the aim of providing wettable flanks for soldering.

The etching step can be carried out (using conventional technology) masking the bottom surface of the leadframe and performing (half) etching by removing metal material at those locations where wettable flanks are desired.

Such as step may involve applying a resist layer (shown and not referenced in Figure 5C for simplicity) onto the front or top surface of the leadframe. The purpose of the resin layer is to protect the surface 10A against damage due to acid attack during removal of the pillar formations 100.

Such processing can be extended to the locations where the pillar formations 100 (as noted, one is illustrated for simplicity, but a plurality of those may be advantageously used) are provided.

As illustrated in the figures, a (blind) hole 100A can be advantageously provided in the die pad 10 at the location where the (each) pillar formation 100 is provided.

As visible in figures such as Figures 5A and 5B, the blind hole 100A is provided with an opening at the front of top surface 10A of the die pad and a blind, closed end at the back or bottom surface 10B where the pillar formation 100 is provided.

As visible in Figure 5D, removing the pillar formation 100 causes the blind hole 100A to become a through hole extending between the opposed surfaces 10A and 10B of the die pad 10.

Figure 5E is exemplary of a semiconductor chip or die 16 (one is illustrated for simplicity, but plural chips can be provided) mounted onto the front of top surface 10A of the die pad 10.

This may be via attach material (of any type known to those of skill in art, not visible in the figures).

After the possible formation of a wire bonding pattern 18 to provide electrical connections between the chip or chips 16 and electrically-conductive leads in the leadframe (see 14 in Figures 4A and 4B), encapsulation material 20 such as an epoxy resin, for instance, can be molded onto the resulting structure in order to complete the semiconductor device package.

As illustrated in Figure 5F, the encapsulation material 20 (which is in a flowable state when molded) can penetrate into the through hole 100A thus advancing from the front or top surface 10A to the bottom or back surface 10B of the die pad 10 and onto the pre-mold material 12.

As a result of the pre-mold material 12 and the encapsulation material 20 being solidified (via UV or heat curing, for instance), this arrangement provides a strong coupling of the encapsulation 20 as generally desirable both to the die pad 10 and to the pre-mold material 12, also when the resin materials 12 and 20 have different filler contents (types and amounts of fillers) .

It is noted that the blind hole (and subsequently through) hole 100A will have a cross-sectional area at least marginally smaller than the homologous cross-sectional area of the pillar formation 100. As a consequence, the pillar formation 100, once removed, will leave an empty space in the material 12 of a larger cross-sectional area of the hole 100A.

Consequently, the encapsulation material 20 penetrating into the hole 100A and on to the pre-mold material 12 will end up by exhibiting an inverted-T (or inverted-mushroom shape) with a distal portion larger than the stem portion extending through the hole 100A.

As a result, the encapsulation 20, once solidified - like the mold material 12 - will provide a robust form coupling to anchor the materials 12 and 20 with the die pad 10 sandwiched therebetween.

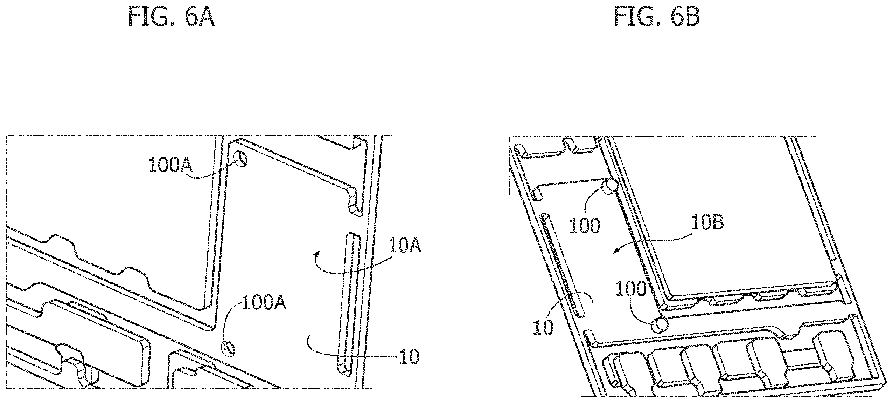

Figures 6A and 6B are illustrative of possible implementations of a sculptured, electrically conductive metal structure of a pre-mold leadframe prior to a pre-mold material such as 12 being molded onto that structure.

Pillar formations 100 are visible provided at the back or bottom surface 10B of a die pad 10, with blind holes 100A provided at the front or top surface 10A at locations corresponding to the locations where the pillar formations 100 are provided.

Examples as described herein provide temporary pillar structures such as 100 connected to die pads 10 for which insulation is desirable.

The pillar formations 100 create a (localized) portion of an otherwise half-etched die pad having a thickness D1 of metal material that facilitates adequate clamping of the leadframe between the clamping surfaces TPS, BPS of the clamping tool.

In that way, with the laminar structure 10, 14 clamped between the planar clamping surfaces TPS, BPS of the pre-mold tool TP, BP kept at a distance equal to said first thickness D1, the first die pad surface 10A is kept firmly abutting against the first planar clamping surface TPS of the pre-mold tool TP, BP.

Possible displacement of a "floating" die pad 10 as in the case of Figures 2A and 2B, with ensuing flashing of the pre-mold material 12 over the surface 10A as exemplified in Figure 3 is thus effectively countered.

A "clean" die pad surface 10A is thus left exposed by the pre-mold material 12, with such die pad surface 10A exempt from pre-mold material 12 flashed thereon.

At the same time the pillar formation(s) 100 protruding from the second die pad surface 10B (of a height equal to the difference between the thickness D1 and the thickness D2) will comprise a distal end portion left exposed by the pre-mold material 12.

Such pillar formations 100 can be removed, via etching, for instance, which may take place during a processing step intended to form wettable flanks for soldering.

A resulting semiconductor device will thus comprise a sculptured electrically conductive laminar structure 10, 14 having spaces therein and a first thickness D1.

A structure as illustrated includes one or more die pads 10 having a mutually opposed first 10A and second 10B die pad surfaces with a second thickness D2 therebetween which is less than the first thickness (D1) and insulating pre-mold material 12 molded onto the laminar structure 10, 14 penetrating into the spaces in the base metal (e.g. copper) structure to provides a laminar pre-molded substrate (leadframe) having the (first) thickness D1 and including the first die pad surface 10A left exposed by the pre-mold material 12.

A semiconductor device as per the examples herein will also include one or more semiconductor chips or dice 16 mounted on the first die pad surface 10A, with:
the first die pad surface 10A exempt from pre-mold material 12 (undesirably) flashed thereon, and
the second die pad surface 10B covered by the insulating pre-mold material 12 to provide (desirably) insulation of the die pad 10.

As noted, pillar formations such as 100 are advantageously formed with a hollow structure which facilitates encapsulation flow during final assembly of the package to complete isolation of the die pad.

An insulating encapsulation 20 can in fact be molded onto the laminar pre-molded substrate (leadframe 10, 12, 14) and one or more semiconductor chips 16 mounted on the first die pad surface 10A.

As a result of removal of the pillar formations 100 the die pad 10 will have through holes 100A therein between the first die pad surface 10A and the second die pad surface 10B.

The encapsulation 20 will thus penetrate into these through holes 100A and contact the pre-mold material 12 in the laminar pre-molded substrate thus providing firm anchoring between the materials 12 and 20 with the leadframe sandwiched therebetween.

The extent of protection is determined by the annexed claims.

## Claims

1. A method, comprising:
providing a sculptured electrically conductive laminar structure (10, 14) having spaces therein, the laminar structure (10, 14) having a first thickness (D1) and including at least one die pad (10) having a first die pad surface (10A) configured to have at least one semiconductor chip (16) mounted thereon and a second die pad surface (10B) opposite the first die pad surface (10A),
clamping the laminar structure (10, 14) between a first planar clamping surface (TPS) and a second planar clamping surface (BPS) of a pre-mold tool (TP, BP) with the first (TPS) and second (BPS) planar clamping surfaces of the pre-mold tool (TP, BP) kept at a distance equal to said first thickness (D1), and
molding insulating pre-mold material (12) onto the laminar structure (10, 14) clamped between the first (TPS) and second (BPS) planar clamping surfaces of the pre-mold tool (TP, BP) kept at a distance equal to said first thickness (D1), wherein the pre-mold material (12) penetrates into said spaces and provides a laminar pre-molded substrate (10, 12, 14) having said first thickness (D1) and including said first die pad surface (10A) left exposed by the pre-mold material (12),
wherein:
the at least one die pad (10) has a second thickness (D2) between the first die pad surface (10A) and the second die pad surface (10B), the second thickness (D2) being less than the first thickness (D1) wherein, with the laminar structure (10, 14) clamped between the first (TPS) and second (BPS) planar clamping surfaces of the pre-mold tool (TP, BP) kept at a distance equal to said first thickness (D1), the first die pad surface (10A) abuts against the first planar clamping surface (TPS) of the pre-mold tool (TP, BP) and the second die pad surface (10B) is at a distance from the second planar clamping surface (BPS) of the pre-mold tool (TP, BP), and
the method comprises providing at least one pillar formation (100) protruding from the second die pad surface (10B) of a height equal to the difference between said first thickness (D1) and said second thickness (D2), wherein, with the laminar structure (10, 14) clamped between the first (TPS) and second (BPS) planar clamping surfaces of the pre-mold tool (TP, BP) kept at a distance equal to said first thickness (D1), the at least one pillar formation (100) abuts against the second planar clamping surface (BPS) of the pre-mold tool (TP, BP),
wherein
the method comprises:
removing said at least one pillar formation (100) subsequent to molding pre-mold material (12) onto the laminar structure (10, 14), and
providing in the first die pad surface (10A) a blind hole (100A) in register with the at least one pillar formation (100) protruding from the second die pad surface (10B), wherein said blind hole becomes a through hole (100A) in response to said at least one pillar formation (100) being removed.

2. The method of claim 1, comprising:
arranging at least one semiconductor chip (16) on said first die pad surface (10A) left exposed by the pre-mold material (12) in the laminar pre-molded substrate, and
subsequent to removing said at least one pillar formation (100), molding an insulating encapsulation (20) onto the laminar pre-molded substrate having the at least one semiconductor chip (16) arranged at said first die pad surface (10A) left exposed by the pre-mold material (12), wherein said insulating encapsulation (20) penetrates into said through hole (100A) and contacts the pre-mold material (12) in the laminar pre-molded substrate.

3. The method of any of the previous claims, wherein the second thickness (D2) between the first die pad surface (10A) and the second die pad surface (10B) is approximately half said first thickness (D1).

4. The method of any of the previous claims comprising providing said sculptured electrically conductive laminar structure (10, 14) having spaces therein by etching laminar metal material.

## Patentansprüche

1. Verfahren, umfassend:
Bereitstellen einer skulptierten elektrisch leitfähigen Laminarstruktur (10, 14), die darin Zwischenräume aufweist, wobei die Laminarstruktur (10, 14) eine erste Dicke (D1) aufweist und mindestens ein Die-Pad (10) aufweist, das eine erste Die-Pad-Oberfläche (10A), die so konfiguriert ist, dass mindestens ein Halbleiterchip (16) darauf montiert werden kann, und eine zweite Die-Pad-Oberfläche (10B) gegenüber der ersten Die-Pad-Oberfläche (10A) aufweist,
Spannen der Laminarstruktur (10, 14) zwischen einer ersten planaren Spannfläche (TPS) und einer zweiten planaren Spannfläche (BPS) eines Vorformwerkzeugs (TP, BP), wobei die erste (TPS) und die zweite (BPS) planare Spannfläche des Vorformwerkzeugs (TP, BP) in einem Abstand gehalten werden, der der ersten Dicke (D1) entspricht, und
Formen von isolierendem Vorformmaterial (12) auf die Laminarstruktur (10, 14), die zwischen der ersten (TPS) und der zweiten (BPS) planaren Spannfläche des Vorformwerkzeugs (TP, BP) gespannt ist, die in einem Abstand gehalten werden, der der ersten Dicke (D1) entspricht, wobei das Vorformmaterial (12) in die Zwischenräume eindringt und ein vorgeformtes Laminarsubstrat (10, 12, 14) bereitstellt, das die erste Dicke (D1) aufweist und die erste Die-Pad-Oberfläche (10A) einschließt, die von dem Vorformmaterial (12) freigelegt bleibt,
wobei:
das mindestens eine Die-Pad (10) eine zweite Dicke (D2) zwischen der ersten Die-Pad-Oberfläche (10A) und der zweiten Die-Pad-Oberfläche (10B) aufweist, wobei die zweite Dicke (D2) kleiner als die erste Dicke (D1) ist, wobei die erste Die-Pad-Oberfläche (10A) bei zwischen der ersten (TPS) und der zweiten (BPS) planaren Spannfläche des Vorformwerkzeugs (TP, BP) eingespannter Laminarstruktur (10, 14), die in einem Abstand gehalten wird, der der ersten Dicke (D1) entspricht, an der ersten planaren Spannfläche (TPS) des Vorformwerkzeugs (TP, BP) anliegt und die zweite Die-Pad-Oberfläche (10B) einen Abstand zu der zweiten planaren Spannfläche (BPS) des Vorformwerkzeugs (TP, BP) aufweist, und
wobei das Verfahren das Bereitstellen mindestens einer Säulenformation (100) umfasst, die aus der zweiten Die-Pad-Oberfläche (10B) mit einer Höhe heraussteht, die der Differenz zwischen der ersten Dicke (D1) und der zweiten Dicke (D2) entspricht, wobei bei zwischen der ersten (TPS) und der zweiten (BPS) planaren Spannfläche des Vorformwerkzeugs (TP, BP) eingespannter Laminarstruktur (10, 14), die in einem Abstand gehalten wird, der der ersten Dicke (D1) entspricht, die mindestens eine Säulenformation (100) an der zweiten planaren Spannfläche (BPS) des Vorformwerkzeugs (TP, BP) anliegt,
wobei
das Verfahren Folgendes umfasst:
Entfernen der mindestens einen Säulenformation (100) nach dem Formen von Vorformmaterial (12) auf die Laminarstruktur (10, 14), und
Bereitstellen eines Blindlochs (100A) in der ersten Die-Pad-Oberfläche (10A), das passgenau mit der mindestens einen Säulenformation (100) ist, die aus der zweiten Die-Pad-Oberfläche (10B) heraussteht, wobei das Blindloch als Reaktion auf das Entfernen der mindestens einen Säulenformation (100) zu einem Durchgangsloch (100A) wird.

2. Verfahren nach Anspruch 1, das Folgendes umfasst:
Anordnen mindestens eines Halbleiterchips (16) auf der ersten Die-Pad-Oberfläche (10A), die von dem vorgeformten Material (12) in dem vorgeformten Laminarsubstrat freigelegt bleibt, und
anschließend an das Entfernen der mindestens einen Säulenformation (100), Formen einer Isolierkapsel (20) auf das vorgeformte Laminarsubstrat, bei dem der mindestens eine Halbleiterchip (16) auf der ersten Die-Pad-Oberfläche (10A) angeordnet ist, die von dem Vorformmaterial (12) freigelegt bleibt, wobei die Isolierkapsel (20) in das Durchgangsloch (100A) eindringt und das Vorformmaterial (12) in dem vorgeformten Laminarsubstrat berührt.

3. Verfahren nach einem der vorhergehenden Ansprüche, wobei die zweite Dicke (D2) zwischen der ersten Die-Pad-Oberfläche (10A) und der zweiten Die-Pad-Oberfläche (10B) etwa die Hälfte der ersten Dicke (D1) beträgt.

4. Verfahren nach einem der vorhergehenden Ansprüche, umfassend das Bereitstellen der skulptierten elektrisch leitenden Laminarstruktur (10, 14), die darin Zwischenräume aufweist, durch Ätzen von laminarem Metallmaterial.

## Revendications

1. Procédé, comprenant :
de fournir une structure laminaire (10, 14) sculptée électriquement conductrice ayant des espaces en elle, la structure laminaire (10, 14) ayant une première épaisseur (D1) et incluant au moins une pastille de connexion (10) ayant une première surface de pastille de connexion (10A) configurée pour avoir au moins une puce semi-conductrice (16) montée dessus et une seconde surface de pastille de connexion (10B) opposée à la première surface de pastille de connexion (10A),
de serrer la structure laminaire (10, 14) entre une première surface de serrage plane (TPS) et une seconde surface de serrage plane (BPS) d'un outil de pré-moulage (TP, BP) avec les première (TPS) et seconde (BPS) surfaces de serrage planes de l'outil de pré-moulage (TP, BP) maintenues à une distance égale à ladite première épaisseur (D1), et
de mouler un matériau pré-moulé (12) isolant sur la structure laminaire (10, 14) serrée entre les première (TPS) et seconde (BPS) surfaces de serrage planes de l'outil de pré-moulage (TP, BP) maintenues à une distance égale à ladite première épaisseur (D1), dans lequel le matériau pré-moulé (12) pénètre dans lesdits espaces et fournit un substrat pré-moulé laminaire (10, 12, 14) ayant ladite première épaisseur (D1) et incluant ladite première surface de pastille de connexion (10A) laissée exposée par le matériau pré-moulé (12),
dans lequel :
l'au moins une pastille de connexion (10) a une seconde épaisseur (D2) entre la première surface de pastille de connexion (10A) et la seconde surface de pastille de connexion (10B), la seconde épaisseur (D2) étant inférieure à la première épaisseur (D1) dans lequel, avec la structure laminaire (10, 14) serrée entre les première (TPS) et seconde (BPS) surfaces de serrage planes de l'outil de pré-moulage (TP, BP) maintenues à une distance égale à ladite première épaisseur (D1), la première surface de pastille de connexion (10A) vient en butée contre la première surface de serrage plane (TPS) de l'outil de pré-moulage (TP, BP) et la seconde surface de pastille de connexion (10B) est à une distance de la seconde surface de serrage plane (BPS) de l'outil de pré-moulage (TP, BP), et
le procédé comprend de fournir au moins une formation en pilier (100) faisant saillie depuis la seconde surface de pastille de connexion (10B) d'une hauteur égale à la différence entre ladite première épaisseur (D1) et ladite seconde épaisseur (D2), dans lequel, avec la structure laminaire (10, 14) serrée entre les première (TPS) et seconde (BPS) surfaces de serrage planes de l'outil de pré-moulage (TP, BP) maintenues à une distance égale à ladite première épaisseur (D1), l'au moins une formation en pilier (100) vient en butée contre la seconde surface de serrage plane (BPS) de l'outil de pré-moulage (TP, BP),
dans lequel
le procédé comprend :
d'enlever ladite au moins une formation en pilier (100) à la suite d'un moulage de matériau pré-moulé (12) sur la structure laminaire (10, 14), et
de fournir dans la première surface de pastille de connexion (10A) un trou aveugle (100A) à niveau avec l'au moins une formation en pilier (100) faisant saillie depuis la seconde surface de pastille de connexion (10B), dans lequel ledit trou aveugle devient un trou traversant (100A) en réponse à ladite au moins une formation en pilier (100) étant enlevée.

2. Procédé selon la revendication 1, comprenant :
d'agencer au moins une puce semi-conductrice (16) sur ladite première surface de pastille de connexion (10A) laissée exposée par le matériau pré-moulé (12) dans le substrat pré-moulé laminaire, et
à la suite de l'enlèvement de ladite au moins une formation en pilier (100), de mouler une encapsulation isolante (20) sur le substrat pré-moulé laminaire ayant l'au moins une puce semi-conductrice (16) agencée au niveau de ladite première surface de pastille de connexion (10A) laissée exposée par le matériau pré-moulé (12), dans lequel ladite encapsulation isolante (20) pénètre dans ledit trou traversant (100A) et entre en contact avec le matériau pré-moulé (12) dans le substrat pré-moulé laminaire.

3. Procédé selon l'une quelconque des revendications précédentes, dans lequel la seconde épaisseur (D2) entre la première surface de pastille de connexion (10A) et la seconde surface de pastille de connexion (10B) est approximativement la moitié de ladite première épaisseur (D1).

4. Procédé selon l'une quelconque des revendications précédentes comprenant de fournir ladite structure laminaire (10, 14) sculptée électriquement conductrice ayant des espaces en elle par gravure d'un matériau métallique laminaire.
